# EUROPÄISCHE PATENTSCHRIFT

(11) **EP 1 053 424 B1**
(45) Veröffentlichungstag und Bekanntmachung des Hinweises auf die Patenterteilung: **25.08.2004**
(21) Anmeldenummer: 99963204.5
(22) Anmeldetag: 05.11.1999
(51) Int. Cl.: F16K 31/00

(54) **PIEZOELEKTRISCHER AKTOR**
PIEZOELECTRIC ACTUATOR
ACTIONNEUR PIEZOELECTRIQUE

(30) Priorität: 05.12.1998 DE 19856186
(43) Veröffentlichungstag der Anmeldung: 22.11.2000
(73) Patentinhaber: ROBERT BOSCH GMBH, 70442 Stuttgart (DE)
(72) Erfinder: HEINZ, Rudolf, D-71272 Renningen (DE)
(86) Internationale Anmeldenummer: PCT/DE1999/003531
(87) Internationale Veröffentlichungsnummer: WO 2000/034700

(56) Entgegenhaltungen:
- DE-A- 19 650 900
- GB-A- 1 320 057
- US-A- 4 051 396
- US-A- 5 148 077
- US-A- 5 295 288

## Beschreibung

### Stand der Technik

Die Erfindung geht aus von einem piezoelektrischen Aktor, nach dem Oberbegriff von Anspruch 1.

Ein derartiger piezoelektrischer Aktor ist zum Beispiel bekannt aus US 5 148 077.

Wie allgemein bekannt, können piezoelektrische Aktoren zum Beispiel für Einspritzventile eines Kraftfahrzeugmotors sowie in Bremssystemen mit Antiblockiersystem und Antischlupfregelungen eingesetzt werden.

Derartige mit piezoelektrischen Aktoren ausgestattete Einspritzventile besitzen eine durch ein stößelartiges Verschlussorgan gesteuerte Einspritzdüse. Am Stößel ist eine düsenseitige Wirkfläche angeordnet, die vom Druck des der Düse zugeführten Kraftstoffs beaufschlagt wird, wobei die Druckkräfte den Stößel in Öffnungsrichtung des Verschlussorganes zu drängen suchen. Der Stößel ragt mit einem plungerartigen Ende, dessen Querschnitt größer ist als die vorgenannte Wirkfläche, in eine Steuerkammer hinein. Der dort wirksame Druck sucht den Stößel in Schließrichtung des Verschlussorganes zu bewegen. Die Steuerkammer ist über eine Eingangsdrossel mit der unter hohem Druck stehenden Kraftstoffzufuhr und über ein in der Regel gedrosseltes bzw. mit einer Ausgangsdrossel kombiniertes Auslassventil mit einer nur geringen druckaufweisenden Kraftstoffrückführleitung verbunden. Bei geschlossenem Auslassventil steht in der Steuerkammer ein hoher Druck an, durch den der Stößel gegen den Druck an seiner düsenseitigen Wirkfläche in Schließrichtung des Verschlussorganes bewegt bzw. in Verschlussstellung gehalten wird. Beim Öffnen des Auslassventils fällt der Druck in der Steuerkammer ab, wobei das Maß des Druckabfalles durch die Bemessung der Eingangsdrossel und des Drosselwiderstandes des geöffneten Ausgangsventiles bzw. der damit kombinierten Ausgangsdrossel bestimmt wird. Im Ergebnis vermindert sich der Druck in der Steuerkammer bei geöffnetem Auslassventil derart, dass der Stößel aufgrund der an seiner düsenseitigen Wirkfläche wirksamen Druckkräfte in Öffnungsrichtung des Verschlussorgans bewegt bzw. in Offenstellung gehalten wird.

Im Vergleich mit elektromagnetisch betätigten Einspritzventilen können piezoelektrische Aktoren schneller schalten. Allerdings muss beim Aufbau eines piezoelektrischen Aktors beachtet werden, dass durch innere Verluste im piezoelektrischen Körper des Aktors Verlustwärme entsteht, die abgeführt werden muss, damit sich der Aktor nicht überhitzt. Da die Keramikmaterialien der Piezokeramik eine schlechte Wärmeleitfähigkeit haben, ist die Ableitung innerhalb des im wesentlichen aus Keramikmaterial bestehenden Aktorkörpers ungünstig.

Die durch den Aktor erzeugte Wärme staut sich im Zwischenraum zwischen dem Aktorkörper und der Modulwand, wenn darin nur Luft vorhanden ist.

Eine Kühlung des Aktors mit einem flüssigen Kühlmittel, wie z.B. Kraftstoff, Wasser, Motoröl und dergleichen, ist ebenfalls ungünstig, zum einen, wegen der Gefahr eines Kurzschlusses durch den auch im Kraftstoff und im Motoröl enthaltenen Wasseranteil und zum anderen, wegen der Verteuerung des Aktormoduls aufgrund aufwendiger Abdichtungen, um eine Leckage des verwendeten Kühlmittels insbesondere bei der Erwärmung des Aktors auszuschließen.

Aus der US 5,148,077 und der US 5,295,288 sind Piezoaktoren bekannt, bei denen ein Zwischenraum zwischen dem Aktorkörper und einer Modulwand mit einem wärmeleitfähigen festen Stoff gefüllt ist.

Es ist Aufgabe der Erfindung, einen gattungsgemäßen piezoelektrischen Aktor so zu ermöglichen, dass eine weiter verbesserte Kühlung im Betrieb desselben möglich ist, und dass der piezoelektrische Aktor einfach montiert werden kann. Ein erfindungsgemäßer piezoelektrischer Aktor hat somit den Vorteil, dass der erwärmte Aktorkörper ohne Kraftstoff, Motoröl oder Wasser, d.h. ohne die Gefahr der Erzeugung eines Kurzschlusses infolge des Wasseranteils und auch ohne Leckagegefahr, gekühlt werden kann.

Die Viskosität des als Kühlmedium dienenden Stoffs ist erfindungsgemäß so gewählt, dass dieser Stoff, z.B. ein Wachs bei höheren Temperaturen, die zwischen 50°C und 100°C liegen können, in den flüssigen Zustand übergeht. Die Bildung der Flüssigphase des Stoffs bei höherer Temperatur intensiviert die Kühlung und die Kühlung bleibt ausreichend hoch.

Bei Raumtemperatur und darunter zeigt der Aktor etwas geringeren Hub. Die Phase des geringeren Hubes wird durch eine schnellere Erwärmung rasch durchfahren.

Im festen Zustand des Stoffs ist die Kühlung nur mäßig, d.h., der Aktor geht sehr schnell durch Eigenerwärmung in den Betriebszustand mit höherem Hub über, bevor dann die Kühlung durch Verflüssigung des Stoffs einsetzt.
Bevorzugt ist Sorge getragen, dass der Zwischenraum des erfindungsgemäßen piezoelektrischen Aktors nicht vollständig vom Stoff ausgefüllt ist, so dass sich letzterer bei Erwärmung des Aktors in einen Luft oder Gas enthaltenden Raum ausdehnen kann.

Damit keine Behinderung des Aktorhubs eintritt, ist die Modulwand, die z.B. aus Metall besteht, innen mit einer Antihaftbeschichtung beschichtet, welche die Haftung des Stoffs an der Wand verhindert.

Auch die Oberfläche des Aktorkörpers kann mit einer solchen, z.B. aus PTFE bestehenden, Antihaftbeschichtung versehen sein.

Weiterhin bevorzugt ist der Aktorfuß durch ein Dichtmittel, z.B. einen Klebstoff, gegen den den Stoff enthaltenden Zwischenraum abgedichtet, so dass der verflüssigte Stoff nicht aus dem Aktormodul austreten kann.

Nachstehend werden weitere Merkmale und Vorteile der Erfindung in der nachfolgenden Ausführungsbeispiele der Erfindung beschreibenden Beschreibung deutlich, wenn diese bezugnehmend auf die Zeichnung gelesen wird.

### Zeichnung

Die einzige Figur zeigt eine Ausführungsform eines erfindungsgemäßen piezoelektrischen Aktors, in Form einer schematischen Längsschnittdarstellung.

### Ausführungsbeispiele

Bei dem in der Figur als Teilschnitt in Längsrichtung dargestellten ersten Ausführungsbeispiel eines erfindungsgemäßen piezoelektrischen Aktors ist ein Aktorkörper 1, der die Form eines vielschichtigen Laminats aus aufeinandergeschichteten Lagen piezoelektrischen Materials und dazwischenliegenden metallischen bzw. elektrisch leitenden, als Elektroden dienenden Schichten haben kann, mit seiner unteren Stirnseite an einem Aktorfuß 6 festgelegt und unter Einhaltung eines Zwischenraums 7 von einer Modulwand 2 umgeben. Ein linksseitiges und rechtsseitiges Federband 12 spannt den Aktorkörper 1 zwischen dem Aktorfuß 6 und einem oberen (nicht bezeichneten) Ringflansch elastisch vor.

Wenn der Aktorkörper 1 mit einer pulsierenden elektrischen Spannung an seinen Elektroden beaufschlagt wird, führt er analog pulsierende Hübe unter Änderung des Abstandes zwischen seinen zwischen dem oberen Ringflansch und dem Aktorfuß 6 durch die Federbänder 12 eingespannten Stirnseiten aus. Diese Hübe werden über einen Kolben 10 auf die (nicht dargestellte) Nadel eines Ventils übertragen (siehe Wirkungspfeil S). Zu bemerken ist außerdem, dass die Elektrodenzuleitungen nach unten zu nicht näher bezeichneten Anschlussklemmen geführt sind.

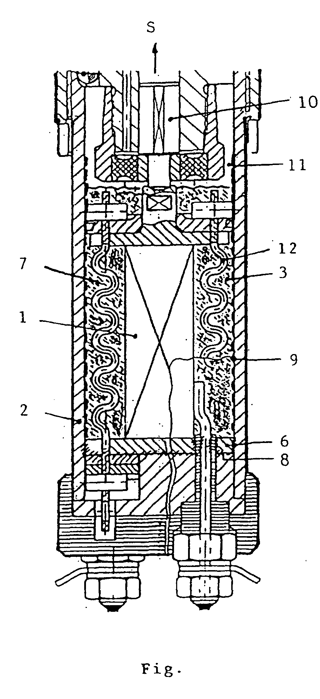

Bei der Ausführungsform gemäß Figur 1 ist der Zwischenraum 7 zwischen dem Aktorkörper 1 und der metallischen Modulwand 2 mit einem niedrigviskosen Elastomer 3 oder einem anderen elastischen Stoff gefüllt, der elektrisch isolierend ist. Außerdem können wärmeleitfähige Partikel 4 dem elastischen Stoff 3 zugemischt werden.

Der Stoff 3 ist elastisch und hat niedrige Viskosität, um die Hübe des Aktorkerns nicht zu behindern.

Zu bemerken ist in Figur 1 auch, dass der Stoff 3 ggf. mit den wärmeleitfähigen Partikeln 4 und den Luftblasen 5 auch den Raum über dem oberen Ringflansch, d.h. den Raum 11 um den Kolben 10 herum ausfüllt, da dieser Raum nicht gegenüber dem unteren Teil des Zwischenraums 7 abgeschlossen ist.

Die die Kühlung wird dadurch weiter verbessert, dass der Zwischenraum 7 durch einen Stoff 3, z.B. ein Wachs, ausgefüllt ist, welcher bzw. welches bei höheren Temperaturen, z.B. im Bereich 50°C bis 100°C, in den flüssigen Zustand übergeht. Damit ist eine schnelle Aufheizung des Aktors auf Betriebstemperatur und danach eine intensive Kühlung aufgrund des flüssigen Zustands des als Wärmeleitmedium dienenden Stoffes 3 erreicht. Bei Demontage hat man keine Wieder-Befüll-Probleme, da im abgekühlten Zustand der Stoff 3 in festem Zustand ist. Der als Wärmeleitmittel dienende Stoff 3 zeigt eher plastische Eigenschaft, wenn dafür ein Wachs gewählt ist.

Im oberen Teil, d.h. in dem den Kolben 10 umgebenden Raum 11, ist 2 eine Luft- oder Gasfüllung vorgesehen, die ihrerseits zur Dehnungsaufnahme bei Wärmedehnung des Stoffs 3 dient. Damit der Stoff 3 im festen Zustand nicht die Aktordehnung behindert, ist die Wand 2 des Aktormoduls innen mit einer Antihaftbeschichtung 9 versehen, die die Haftung des Stoffs 3 an der Innenwand verhindert. Diese Antihaftbeschichtung kann z.B. aus PTFE , z.B. Teflon (Geschützte Marke) bestehen. Auch die Oberfläche des Aktorkörpers 1 kann mit einer solchen Antihaftbeschichtung versehen sein.

Vorteil ist, dass bei tiefen Temperaturen (bis - 40 ° C) das Kühlmedium 3 sich durch Zusammenziehen von der Wand löst, die Wärmeleitfähigkeit dadurch zusätzlich verschlechtert wird und damit der Aktor 1 schneller auf Betriebstemperatur kommt. Dies gilt auch bei Füllung mit dem Elastomer 3 und Antihaftbeschichtung der Innenwand von 2.

Zu erwähnen ist außerdem, dass die Bodenplatte 6 wegen der Flüssigphase des Kühlmittels 3 durch ein Dichtmittel 8, z.B. durch Klebstoff abgedichtet ist.

Somit intensiviert bei der Bildung einer Flüssigphase des Stoffs 3 die Kühlung bei höherer Temperatur ins besondere bei Betriebstemperatur. Bei Raumtemperatur und darunter kann der Aktorkörper 1 einen geringeren Hub zeigen. Im festen Zustand des Stoffs 3 ist die Kühlwirkung durch Wärmeleitung des Stoffs 3 vermindert, d.h. der Aktorkörper 1 geht sehr schnell durch Eigenerwärmung in seinen Betriebszustand mit höherem Hub über, bevor dann die Kühlung durch Verflüssigung des Stoffs 3 einsetzt.

Die Antihaftbeschichtung der Modulwand 2 und eventuell auch der Wand des Aktorkörpers 1 verhindert eine mögliche Hubabsenkung des Aktors durch den Stoff 3.

## Patentansprüche

1. Piezoelektrischer Aktor, insbesondere zur Betätigung von Steuerventilen oder Einspritzventilen an Verbrennungsmotoren in Kraftfahrzeugen, mit einem piezoelektrischen Aktorkörper (1) insbesondere in Form eines vielschichtigen Laminats aus aufeinandergeschichteten Lagen piezoelektrischen Materials und dazwischenliegenden metallischen bzw. elektrisch leitenden, als Elektroden dienenden Schichten, wobei eine der Stirnseiten des Aktorkörpers (1) an einem Aktorfuß (6) festgelegt ist und der Aktorkörper (1) unter Einhaltung eines Zwischenraums (7) von einer Modulwand (2) umgeben ist, wobei der Zwischenraum (7) mit einem elastischen oder plastischen, elektrisch isolierenden Stoff (3) guter Wärmeleitfähigkeit ausgefüllt ist, der zumindest im Temperaturbereich unter der Betriebstemperatur des Aktors fest ist, **dadurch gekennzeichnet, dass** als wärmeleitender Stoff (3) ein solcher gewählt ist, der bei höheren Temperaturen in den flüssigen Zustand übergeht.

2. Piezoelektrischer Aktor nach Anspruch 1, **dadurch gekennzeichnet, dass** der Stoff (3) ein Wachs ist.

3. Piezoelektrischer Aktor nach Anspruch 1 oder 2, **dadurch gekennzeichnet, dass** der Stoff (3) mit wärmeleitfähigem Füllstoff (4) gefüllt ist.

4. Piezoelektrischer Aktor nach einem der vorangehenden Ansprüche, **dadurch gekennzeichnet, dass** die Verflüssigungstemperatur des Stoffs (3) zwischen 50°C und 100°C gewählt ist.

5. Piezoelektrischer Aktor nach einem der vorhergehenden Ansprüche, **dadurch gekennzeichnet, dass** der Zwischenraum (7) nicht vollständig vom Stoff (3) ausgefüllt ist, so dass sich letzterer bei Erwärmung in einen Luft oder Gas enthaltenden Raum (11) ausdehnen kann.

6. Piezoelektrischer Aktor nach einem der vorhergehenden Ansprüche, **dadurch gekennzeichnet, dass** die Modulwand (2) innen mit einer Antihaftbeschichtung (9) beschichtet ist, welche die Haftung des Stoffs (3) an der Wand verhindert.

7. Piezoelektrischer Aktor nach einem der vorhergehenden Ansprüche, **dadurch gekennzeichnet, dass** die Oberfläche des Aktorkörpers (1) mit einer Antihaftbeschichtung (9) versehen ist.

8. Piezoelektrischer Aktor nach Anspruch 6 oder 7, **dadurch gekennzeichnet, dass** die Antihaftbeschichtung (9) aus PTFE besteht.

9. Piezoelektrischer Aktor nach einem der vorhergehenden Ansprüche, **dadurch gekennzeichnet, dass** der Aktorfuß (6) gegen den den Stoff (3) enthaltenden Zwischenraum (7) durch ein Dichtmittel abgedichtet ist.

10. Piezoelektrischer Aktor nach Anspruch 9, **dadurch gekennzeichnet, dass** das Dichtmittel ein Klebstoff ist.

## Claims

1. Piezoelectric actuator, in particular for actuating control valves or injection valves in internal combustion engines in motor vehicles, having a piezoelectric actuator body (1), in particular in the form of a multilayer laminate of layered plies of piezoelectric material and interposed metallic or electrically conducting layers serving as electrodes, one of the end faces of the actuator body (1) being fixed on an actuator base (6) and the actuator body (1) being surrounded by a module wall (2), while maintaining an intermediate space (7), the intermediate space (7) being filled with an elastic or plastic, electrically insulating material (3) of good thermal conductivity, which is solid at least in the temperature range below the operating temperature of the actuator, **characterized in that** a material which goes over into the liquid state at elevated temperatures is chosen as the heat-conducting material (3).

2. Piezoelectric actuator according to Claim 1, **characterized in that** the material (3) is a wax.

3. Piezoelectric actuator according to Claim 1 or 2, **characterized in that** the material (3) is filled with thermally conductive filler (4).

4. Piezoelectric actuator according to one of the preceding claims, **characterized in that** the liquefying temperature of the material (3) is chosen to be between 50°C and 100°C.

5. Piezoelectric actuator according to one of the preceding claims, **characterized in that** the intermediate space (7) is not completely filled by the material (3), so that, when it is heated, the latter can expand into a space (11) containing air or gas.

6. Piezoelectric actuator according to one of the preceding claims, **characterized in that** the module wall (2) is coated on the inside with a non-stick coating (9), which prevents the material (3) from adhering to the wall.

7. Piezoelectric actuator according to one of the preceding claims, **characterized in that** the surface of the actuator body (1) is provided with a non-stick coating (9).

8. Piezoelectric actuator according to Claim 6 or 7, **characterized in that** the non-stick coating (9) consists of PTFE.

9. Piezoelectric actuator according to one of the preceding claims, **characterized in that** the actuator base (6) is sealed off from the intermediate space (7) containing the material (3) by a sealing means.

10. Piezoelectric actuator according to Claim 9, **characterized in that** the sealing means is an adhesive.

## Revendications

1. Actionneur piezzo-électrique, en particulier pour actionner des soupapes de commande ou des injecteurs dans des moteurs à combustion interne de véhicules automobiles qui comprend un corps d'actionneur (1), notamment sous la forme d'un aggloméré laminé multicouche composé d'une superposition de couches d'un matériau piezzo-électrique et, entre celles-ci, de couches intermédiaires métalliques, c'est-à-dire conductrices d'électricité, qui servent d'électrodes, le corps d'actionneur (1) étant fixé par une de ses faces frontales sur un pied d'actionneur (6) et étant entouré par une paroi de module (2) avec maintien d'un espace intermédiaire (7) rempli par une matière élastique ou plastique isolante électriquement (3) et présentant une bonne conductibilité thermique, cette matière étant solide au moins dans la plage de température située en dessous de la température de fonctionnement de l'actionneur,
**caractérisé en ce que**
comme matière conductrice de la chaleur (3), on choisit une matière qui, à des températures plus élevées, passe à l'état liquide.

2. Actionneur piezzo-électrique selon la revendication 1,
**caractérisé en ce que**
la matière (3) est une cire.

3. Actionneur piezzo-électrique selon la revendication 1 ou 2,
**caractérisé en ce que**
la matière (3) est remplie d'une charge (4) conductrice de la chaleur.

4. Actionneur piezzo-électrique selon une des revendications précédentes,
**caractérisé en ce que**
la température de fusion de la matière (3) est choisie entre 50°C et 100°C.

5. Actionneur piezzo-électrique selon une des revendications précédentes,
**caractérisé en ce que**
l'espace intermédiaire (7) n'est pas totalement rempli de la matière (3), de sorte que celle-ci peut se dilater quand elle s'échauffe, dans un espace (11) contenant de l'air ou un gaz.

6. Actionneur piezzo-électrique selon une des revendications précédentes,
**caractérisé en ce que**
la paroi de module (2) est garnie intérieurement d'un revêtement anti-adhérence (9) empêchant la matière (3) d'adhérer à la paroi.

7. Actionneur piezzo-électrique selon une des revendications précédentes,
**caractérisé en ce que**
la surface du corps d'actionneur (1) porte un revêtement anti-adhérence (9).

8. Actionneur piezzo-électrique selon la revendication 6 ou 7,
**caractérisé en ce que**
le revêtement anti-adhérence (9) est en PTFE.

9. Actionneur piezzo-électrique selon une des revendications précédentes,
**caractérisé en ce que**
le pied d'actionneur (6) est isolé de la chambre intermédiaire (7) contenant la matière (3) par un moyen d'étanchéité.

10. Actionneur piezzo-électrique selon la revendication 9,
**caractérisé en ce que**
le moyen d'étanchéité est une matière adhésive.
